# EUROPEAN PATENT APPLICATION

(11) **EP 4 730 311 A1**
(43) Date of publication of application: **22.04.2026**
(21) Application number: 23956540.1
(22) Date of filing: 27.10.2023
(51) Int. Cl.: G09G 3/32, G02F 1/13357, H10H 20/857

(54) **LIGHT-EMITTING SUBSTRATE, BACKLIGHT MODULE AND DISPLAY APPARATUS**

(71) Applicant: Boe Technology Group Co., Ltd., Beijing 100015 (CN); Hefei Boe Ruisheng Technology Co., Ltd., Hefei, Anhui 230012 (CN)
(72) Inventor: LIU, Chunjian, Beijing 100176 (CN); TIAN, Jian, Beijing 100176 (CN); MA, Yajun, Beijing 100176 (CN); LEI, Jie, Beijing 100176 (CN); ZHANG, Jianying, Beijing 100176 (CN)
(74) Representative: Brötz, Helmut
(86) International application number: PCT/CN2023/127380
(87) International publication number: WO 2025/086300

(57) **Abstract**

Provided are a light-emitting substrate, a backlight module, and a display apparatus. The light-emitting substrate comprises a base substrate, multiple first drive units, multiple first wires and a second drive unit. Each first drive unit comprises at least one first drive portion and a drive connection portion, the first drive portion comprising at least one drive port portion, and the drive port portion comprising multiple drive ports. The first wires are connected to the first drive units, and the multiple first wires and the multiple first drive units are located in the same conductive pattern layer. At least a portion of the second drive unit is located between two first drive units adjacent to each other in a first direction, and the second drive unit comprises multiple connection ends, the number of the connection ends in the second drive unit being larger than the number of the drive ports in the drive port portion. Since the first wires and the first drive units of the light-emitting substrate are located in the same conductive pattern layer, external monitoring devices can be disposed at the multiple connection ends to facilitate monitoring the operating state of the light-emitting substrate.

## Description

### TECHNICAL FIELD

At least one embodiment of the present disclosure relates to a light-emitting substrate, a backlight module and a display apparatus.

### BACKGROUND

In recent years, the MLED industry has developed rapidly, and the application of MLED backlight sources has become more and more extensive. MLED includes Mini-LED (size is generally 50µm to 300µm) and Micro-LED (size is generally less than 50µm). In comparison, because of great difficulty of the mass transfer technology, and technology of the Micro-LED is not yet mature, therefore, the Mini-LED, as a transitional product of the Micro-LED, has received widespread attention and research. The Mini-LED has good display performance and thinness, and has advantages of high contrast and long life.

### SUMMARY

Embodiments of the present disclosure provide a light-emitting substrate, a backlight module and a display apparatus.

Embodiments of the present disclosure provide a light-emitting substrate, which includes: a base substrate, a plurality of first drive units, a plurality of first wires, a plurality of first drive units are located on the base substrate and arranged in an array mode in a first direction and a second direction, the first direction and the second direction are both parallel to the base substrate and intersect, each of the plurality of first drive units includes at least one first drive portion and a drive connecting portion, each of the at least one first drive portion includes at least one drive port portion, each of the at least one drive port portion includes a plurality of drive ports, and the drive connecting portion is configured to be connected with a drive circuit; each of the plurality of first wires extends in the second direction, each of the plurality of first wires is connected with the first drive unit, and the plurality of first wires are located in a same conductive pattern layer with the first drive unit; the light-emitting substrate further includes a second drive unit which is located on the base substrate, at least a portion of the second drive unit is located between two first drive units which are adjacent in the first direction, and the second drive unit includes a plurality of connecting ends, and a count of the plurality of connecting ends in the second drive unit is larger than a count of the plurality of drive ports in the drive port portion.

For example, according to the light emitting substrate provided by at least one embodiment of the present disclosure, the second drive unit is located in in the same conductive pattern layer.

For example, according to the light emitting substrate provided by at least one embodiment of the present disclosure, the light-emitting substrate further includes a plurality of second wires each of which extends in the second direction, and each of the plurality of second wires being connected with one of the plurality of connecting ends in the second drive unit, the plurality of second wires are located in the same conductive pattern layer.

For example, according to the light emitting substrate provided by at least one embodiment of the present disclosure, the light-emitting substrate further includes a light-emitting element and a sensor, the light-emitting element is connected with the plurality of drive ports in the drive port portion, the drive circuit transmits a drive signal to the drive port portion in the first drive portion through the drive connecting portion so that the light-emitting element emits light; the sensor is connected with the plurality of connecting ends in the second drive unit and is configured to monitor a temperature of the light-emitting substrate.

For example, according to the light emitting substrate provided by at least one embodiment of the present disclosure, the plurality of first wires include a first scanning line and a second scanning line, the first scanning line and the second scanning line which have the smallest distance in the first direction are located between two adjacent first drive units, the first scanning line is connected with one of the two adjacent first drive units, and the second scanning line is connected with the other one of the two adjacent first drive units; and at least a portion of the second drive unit is located between the first scanning line and the second scanning line which have the smallest distance in the first direction.

For example, according to the light emitting substrate provided by at least one embodiment of the present disclosure, the plurality of connecting ends of the second drive unit include a first connecting end, a second connecting end, a third connecting end and a fourth connecting end; the plurality of second wires include a first signal line, a second signal line, a third signal line and a fourth signal line, the first signal line is connected with the first connecting end and configured to transmit a first common voltage signal, the second signal line is connected with the second connecting end and configured to transmit a first power signal; the third signal line is connected with the third connecting end and configured to transmit a first input signal, and the fourth signal line is connected with the fourth connecting end and configured to transmit a first output signal.

For example, according to the light emitting substrate provided by at least one embodiment of the present disclosure, the drive port portion include two drive ports.

For example, according to the light emitting substrate provided by at least one embodiment of the present disclosure, the first scanning line and the first signal line are of an integrated structure; and the first scanning line includes a main body portion and a protruding portion, the main body portion extends in the second direction, the protruding portion protrudes relative to the main body portion in the first direction, and the protruding portion and the first connecting end of the second drive unit are of an integrated structure.

For example, according to the light emitting substrate provided by at least one embodiment of the present disclosure, the second connecting end, the third connecting end and the fourth connecting end are all located between the first scanning line and the second scanning line which have the smallest distance in the first direction; and the second signal line, the third signal line and the fourth signal line are all located between the first scanning line and the second scanning line which have the smallest distance.

For example, according to the light emitting substrate provided by at least one embodiment of the present disclosure, the second signal line is located between the first connecting end and the third connecting end in the first direction, the second connecting ends of the second drive units located in a same column are connected with the same second signal line, and the fourth connecting end of the second drive unit is connected with the third connecting end of the second drive unit adjacent thereto through the fourth signal line.

For example, according to the light emitting substrate provided by at least one embodiment of the present disclosure, the first connecting end, the second connecting end, the third connecting end and the fourth connecting end are arranged in an array with two rows and two columns in the first direction and the second direction; and the second connecting end and the fourth connecting end are adjacent to each other in the first direction, and the first connecting end and the second connecting end are adjacent to each other in the second direction.

For example, according to the light emitting substrate provided by at least one embodiment of the present disclosure, in second drive units located in the same column in the second direction, the third connecting end of the second drive unit located in a N^{th} row is located on a side of the fourth connecting end of the second drive unit, away from the second drive unit located in a (N+1)^{th} row, and N is a positive integer.

For example, according to the light emitting substrate provided by at least one embodiment of the present disclosure, the drive connecting portion and the second drive unit are arranged at intervals in the first direction and the second direction.

For example, according to the light emitting substrate provided by at least one embodiment of the present disclosure, the first drive unit and the second drive unit are arranged at intervals in the first direction; and/or the first drive unit and the second drive unit are arranged at intervals in the second direction.

For example, according to the light emitting substrate provided by at least one embodiment of the present disclosure, the drive connecting portion in the first drive unit includes a plurality of drive connecting end; and the first drive unit includes one first drive portion, which is connected with one of the plurality of drive connecting ends.

For example, according to the light emitting substrate provided by at least one embodiment of the present disclosure, the drive connecting portion in the first drive unit includes a plurality of drive connecting ends, the first drive unit includes four first drive portions, the plurality of drive connecting ends include four drive sub-connecting ends, and the four first drive portions are in one-to-one correspondence with the four drive sub-connecting ends.

For example, according to the light emitting substrate provided by at least one embodiment of the present disclosure, the light-emitting substrate includes a display portion, and a bonding region which is located at one side of the display portion in the second direction, the bonding region includes a plurality of binding sub-regions; the light-emitting substrate includes a plurality of drive groups, each of the plurality of drive groups includes a plurality of drive unit columns which are sequentially arranged in the first direction, each of the plurality of drive unit columns includes at least one first drive unit, one of the plurality of first wires connected with the first drive unit in the drive group extends to one of the plurality of bonding sub-regions; at least one second drive unit is arranged in the drive group, and the second wire connected with the at least one second drive unit extends to the bonding sub-region.

For example, according to the light emitting substrate provided by at least one embodiment of the present disclosure, the drive group is provided with a column of second drive units; and in the first direction, counts of the drive unit columns at two sides of the second drive unit in the drive group are equal.

For example, according to the light emitting substrate provided by at least one embodiment of the present disclosure, the plurality of drive unit columns include a first drive unit column, a second drive unit column, and a plurality of third drive unit columns; the first drive unit column and the second drive unit column are arranged adjacent to each other in the first direction, at least one third drive unit column is located on a side, away from the second drive unit column, of the first drive unit column, and at least one third drive unit column is located on a side, away from the first drive unit column, of the second drive unit column; and at least a portion of second drive unit is located between the first drive unit column and the second drive unit column, and a count of the plurality of drive unit columns in the drive group is an even number.

For example, according to the light emitting substrate provided by at least one embodiment of the present disclosure, the drive group is provided with a column of second drive units; and in the first direction, counts of the third drive unit columns at two sides of the second drive unit in the drive group are equal.

For example, according to the light emitting substrate provided by at least one embodiment of the present disclosure, one of the plurality of second wires that is connected with the second drive units in the drive group extends to a middle portion of the bonding sub-region.

For example, according to the light emitting substrate provided by at least one embodiment of the present disclosure, the plurality of first wires further include a third scanning line, a fourth scanning line and a fifth scanning line; in the first direction, the second scanning line, the third scanning line, the fourth scanning line, the fifth scanning line and the first scanning line that are connected with the first drive unit are sequentially arranged, and the first drive unit is located between the third scanning line and the fourth scanning line; the first scanning line is configured to transmit a second common voltage signal; the second scanning line is configured to transmit a second power signal; the third scanning line is configured to transmit a third power signal; the fourth scanning line is configured to transmit a second output signal; the fifth scanning line is configured to transmit a third output signal; and in the first direction, a width of the second scanning line, a width of the fourth scanning line and a width of the fifth scanning line are all smaller than a width of the first scanning line and smaller than a width of the third scanning line.

For example, according to the light emitting substrate provided by at least one embodiment of the present disclosure, first scanning lines connected with the first drive units in all of the plurality of third drive unit columns have a same width, which is a first width; and third scanning lines connected with the first drive units in all of the plurality of third drive unit columns have the same width which is a second width, and the first width and the second width are approximately equal.

For example, according to the light emitting substrate provided by at least one embodiment of the present disclosure, a width of the first scanning line connected with first drive units in the first drive unit column is a third width, and the third width is smaller than the first width; and a width of the third scanning line connected with first drive units in the second drive unit column is a fourth width, and the fourth width is smaller than the second width.

For example, according to the light emitting substrate provided by at least one embodiment of the present disclosure, the third width is 80% to 90% of the first width; and/or the fourth width is 80% to 90% of the second width.

For example, according to the light emitting substrate provided by at least one embodiment of the present disclosure, an average length of portions, extending into the bonding sub-region, of the first wires connected with the first drive units in the first drive unit column is a first length; and an average length of portions, extending into the bonding sub-region, of the second wires connected with the second drive units in the drive group is a second length, and the second length is smaller than the first length.

For example, according to the light emitting substrate provided by at least one embodiment of the present disclosure, the first drive unit includes a plurality of first leads, at least one second lead and at least one third lead wire which are located in the conductive pattern layer; adjacent drive port portions are connected through one of the plurality of first leads; the first drive portion is connected with the drive connecting portion through one of the at least one second lead; and the first drive portion is connected with the third scanning line through one of the at least one third lead.

Embodiments of the present disclosure provide a backlight module, which includes the light-emitting substrate according to any one of the above.

Embodiments of the present disclosure provide a display apparatus, which includes the backlight module according to any one of the above.

### BRIEF DESCRIPTION OF DRAWINGS

In order to more clearly explain the technical solutions of the embodiments of the present disclosure, the drawings of the embodiments will be briefly introduced below. Obviously, the drawings in the following description only relate to some embodiments of the present disclosure, and are not limited to the present disclosure.
Fig. 1 is a partial structure schematic diagram of one light-emitting substrate.
Fig. 2 is a partial structure schematic diagram of another light-emitting substrate.
Fig. 3 is a partial structure schematic diagram of a first drive unit of the light-emitting substrate in Fig. 2.
Fig. 4 is a partial structure schematic diagram of a conductive pattern layer of the light-emitting substrate in Fig. 2.
Fig. 5 is a partial structure schematic diagram of a light-emitting substrate with double conductive layers.
Fig. 6 is a partial amplification schematic diagram of a light-emitting substrate with double conductive layers.
Fig. 7 is a partial structure schematic diagram of a light-emitting substrate provided by at least one embodiment of the present disclosure.
Fig. 8 is a partial structure schematic diagram of a conductive pattern layer of the light-emitting substrate in Fig. 7.
Fig. 9 is a partial amplification schematic diagram of the conductive pattern layer in Fig. 8.
Fig. 10 is a partial schematic diagram of a second drive unit corresponding to the light-emitting substrate in Fig. 6 and Fig. 7.
Fig. 11 is a partial structure schematic diagram of another light-emitting substrate provided by at least one embodiment of the present disclosure.
Fig. 12 is a partial structure schematic diagram of a conductive pattern layer of the light-emitting substrate in Fig. 11.
Fig. 13 is a partial amplification schematic diagram of the conductive pattern layer in Fig. 12.
Fig. 14 is a partial amplification schematic diagram of a second drive unit of the light-emitting substrate in Fig. 11.
Fig. 15 is a partial structure schematic diagram of yet another light-emitting substrate provided by at least one embodiment of the present disclosure.
Fig. 16 is a partial amplification schematic diagram of a second drive unit of the light-emitting substrate in Fig. 15.
Fig. 17 is an overall structure schematic diagram corresponding to the light-emitting substrate in Fig. 13.
Fig. 18 is a partial cross-section schematic diagram corresponding to the light-emitting substrate in Fig. 13.

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure. Based on the described embodiments herein, those skilled in the art can obtain other embodiment(s), without any inventive work, which should be within the scope of the disclosure.

Unless otherwise specified, the technical terms or scientific terms used in the disclosure shall have normal meanings understood by those skilled in the art. The words "first", "second" and the like used in the disclosure do not indicate the sequence, the number or the importance but are only used for distinguishing different components. The word "comprise", "include" or the like only indicates that an element or a component before the word contains elements or components listed after the word and equivalents thereof, not excluding other elements or components.

As used in embodiments of the present disclosure, the features "perpendicular", "parallel", and "identical" etc. include the features "perpendicular", "parallel", and "identical," etc. in the strict sense, as well as "approximately perpendicular", "approximately parallel", and "approximately identical," etc., which include a certain amount of error, and are indicated to be within a range of acceptable deviations for a particular value as determined by a person of ordinary skill in the art, taking into account the measurement and the error associated with the measurement of the particular quantity (that is, the limitation of the measurement system). The "center" in the embodiment of the present disclosure may include a strictly geometric center position and a roughly central position in a small area around the geometric center.

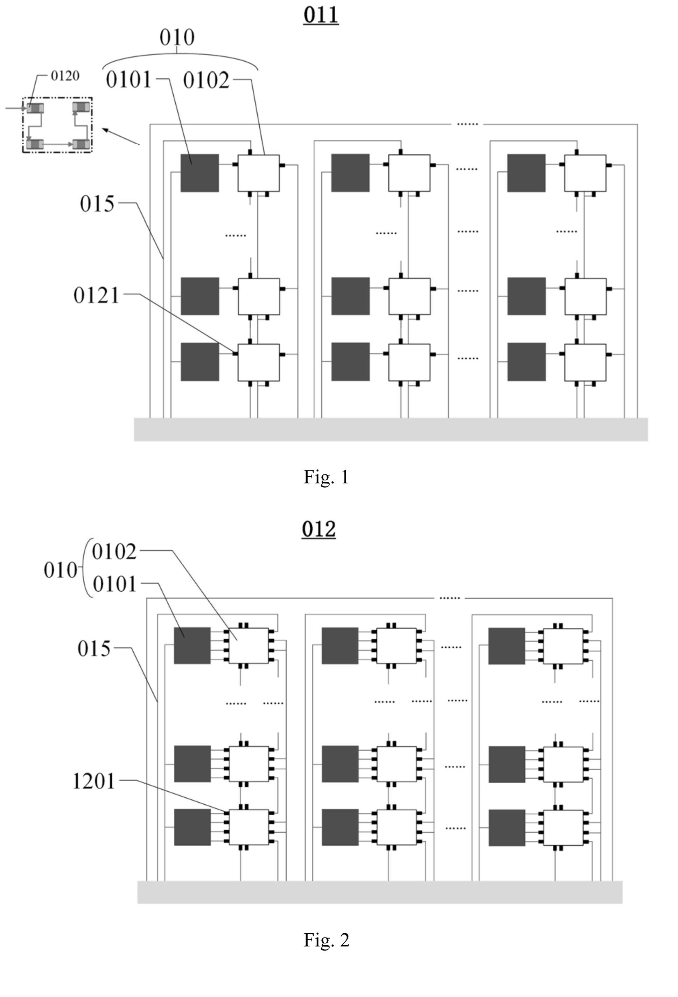

Fig. 1 is a partial structure schematic diagram of a light-emitting substrate.

For example, as shown in Fig. 1, a light-emitting substrate 011 includes a base substrate, a plurality of first drive units 010 located on the base substrate, and first wires 015 connected with the first drive units 010. The plurality of first drive units 010 are arranged in an array mode in a first direction X and a second direction Y, the first direction X and the second direction Y are both parallel to the base substrate and intersect, and for example, the first direction X is perpendicular to the second direction Y.

For example, as shown in Fig. 1, the first drive unit 010 includes a first drive portion 0101 and a drive connecting portion 0102; the first drive portion 0101 is connected with the drive connecting portion 0102; the first drive portion 0101 can include a plurality of drive port portions 0120 which are sequentially connected in series, and the drive port portion 0120 is configured to be connected with a light-emitting element. Therefore, the drive connecting portion 0102 can transmit a drive signal to the first drive portion 0101 so that the first drive portion 0101 can drive the light-emitting element to emit light.

For example, as shown in Fig. 1, in the light-emitting substrate 011, the drive connecting portion 0102 includes a drive connecting end 0121, and the first drive portion 0101 is connected with the drive connecting end 0121. That is, one drive connecting portion 0102 corresponds to one first drive portion 0101, and the corresponding first drive portion 0101 drives the corresponding light-emitting element to emit light.

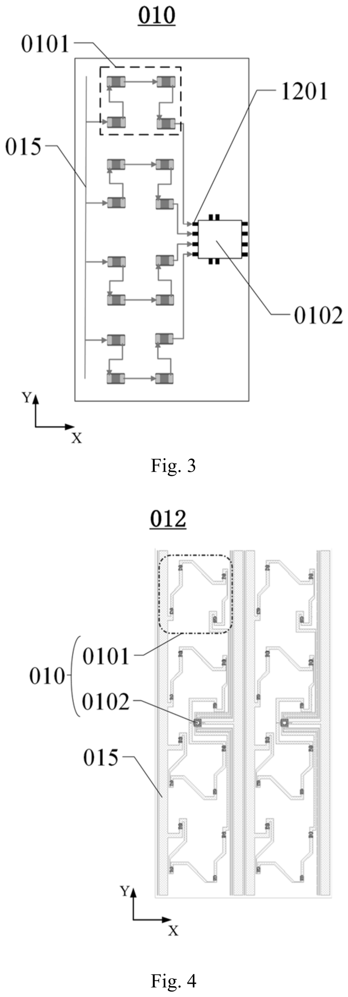

Fig. 2 is a partial structure schematic diagram of another light-emitting substrate; Fig. 3 is a partial structure schematic diagram of a first drive unit of a light-emitting substrate in Fig. 2; and Fig. 4 is a partial structure schematic diagram of a conductive pattern layer of a light-emitting substrate in Fig. 2.

For example, as shown in Fig. 2, the light-emitting substrate 012 includes a base substrate, a plurality of first drive units 010 and a plurality of first wires 015, in which the plurality of first drive units 010 and the plurality of first wires 015 are located on the base substrate. The plurality of first drive units 010 are arranged in an array in the first direction X and the second direction Y.

For example, as shown in Fig. 3, the first drive unit 010 includes four first drive portions 0101, the drive connecting portion 0102 includes four sub-drive connecting ends 1201, and the four first drive portions 0101 in the first drive unit 010 are connected with the four sub-drive connecting ends 1201 in the drive connecting portion 0102 in a one-to-one correspondence manner. That is, one drive connecting portion 0102 corresponds to the four first drive portions 0101, and the four corresponding first drive portions 0101 drive a light-emitting element to emit light.

For example, two first drive units 010 which are adjacently arranged in the first direction X are shown in Fig. 4. The first drive portion 0101 in the first drive unit 010 and the drive connecting portion 0102 are located in the same conductive pattern layer, and the first wire 015 connected with the first drive unit 010 is also located in the same conductive pattern layer. For example, the material of the conductive pattern layer can include copper, so that the light-emitting substrate 012 can have a single conductive pattern layer, such as a "single-layer copper" structure.

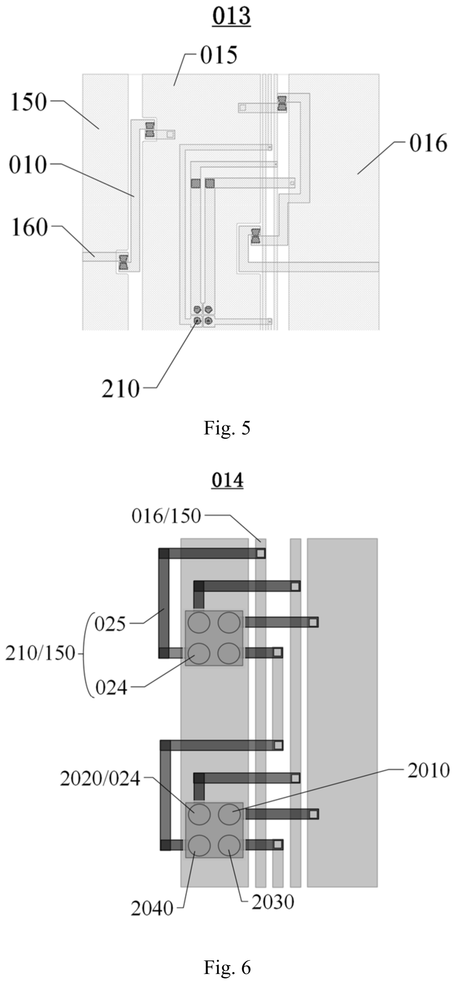

Fig. 5 is a partial structure schematic diagram of a light-emitting substrate with double conductive layers; and Fig. 6 is a partial amplification schematic diagram of a light-emitting substrate with double conductive layers.

For example, as shown in Fig. 5, the light-emitting substrate 013 includes a first conductive layer 150 and a second conductive layer 160; a plurality of first wires 015 and a plurality of second wires 016 are arranged in the first conductive layer 150, and a first drive unit 010 and a second drive unit 210 are arranged in the second conductive layer 160. The first drive unit 010 is connected with the first wire 015, and the second drive unit 210 is connected with the second wire 016. For example, the second drive unit 210 can be connected with a temperature sensor so as to monitor the temperature of the light-emitting substrate 013 through the temperature sensor.

For example, as shown in Fig. 6, the second drive units 210 in the light-emitting substrate 014 include a plurality of connecting ends 024 and a plurality of leads 025; the temperature sensor can be connected with the plurality of connecting ends 024, and the plurality of connecting ends 024 are connected with the plurality of leads 025 in a one-to-one correspondence manner. For example, the second drive unit 210 can include a first connecting end 2010, a second connecting end 2020, a third connecting end 2030 and a fourth connecting end 2040; and the plurality of connecting ends 024 are connected with different second wires 016 through corresponding leads 025. For example, the first connecting end 2010 is configured to transmit a common voltage signal, the second connecting end 2020 is configured to transmit a power signal, the third connecting end 2030 is configured to transmit an input signal, and the fourth connecting ends 2040 is configured to transmit an output signal.

For example, as shown in Fig. 5 and Fig. 6, the first conductive layer 150 and the second conductive layer 160 can be made of copper, so that the light-emitting substrate 013 and the light-emitting substrate 014 can have a "double-layer copper" structure.

In research, the inventor of the present application finds that in a backlight source of a Mini-LED display apparatus, a large number of light-emitting elements need to be driven independently, so that the number of first drive units is large. Compared with the light-emitting substrate of the "double-layer copper" structure, the light-emitting substrate with a single conductive pattern layer such as a "single-layer copper" structure is limited by factors such as layout space, so a performance monitoring apparatus (such as the temperature sensor) is difficult to arrange, and the temperature of the light-emitting substrate cannot be monitored.

Therefore, for the light-emitting substrate with the single conductive pattern layer such as the "single-layer copper" structure, how to reasonably arrange the dense first drive units and second drive units in the same conductive pattern layer to ensure that the light-emitting substrate can normally drive the light-emitting element to emit light, and meanwhile the temperature state of the light-emitting substrate during working can be monitored is an important research problem at present.

At least one embodiment of the present disclosure provides a light-emitting substrate, a backlight module and a display apparatus.

The light-emitting substrate provided by the at least one embodiment of the present disclosure includes a base substrate, a plurality of first drive units, a plurality of first wires and a plurality of second drive units; the plurality of first drive units are located on the base substrate, and are arranged in an array mode in a first direction and a second direction, and the first direction and the second direction are both parallel to the base substrate and intersect; the first drive unit includes at least one first drive portion and a drive connecting portion, the first drive portion includes at least one drive port portion, the drive port portion includes a plurality of drive ports, and the drive connecting portion is configured to be connected with a drive circuit; the first wire extends in the second direction, the first wire is connected with the first drive unit, and the plurality of first wires and the plurality of first drive units are located in the same conductive pattern layer; and at least a portion of the second drive unit is located between two adjacent first drive units in the first direction, the second drive unit includes a plurality of connecting ends, and a total number of the plurality of connecting ends in the second drive unit is greater than a total number of the plurality of drive ports in the drive port portion.

The first drive unit and the first wire in the light-emitting substrate provided by the embodiment of the present disclosure are located in the same conductive pattern layer, so that the light-emitting substrate has a structure of a single conductive pattern layer such as "single-layer copper"; moreover, the light-emitting substrate is further provided with the second drive unit, and the total number of the connecting ends in the second drive unit is greater than that of the drive ports in the drive port portion, so that an external monitoring device (such as the temperature sensor) can be arranged at the plurality of connecting ends to monitor the operating state of the light-emitting substrate, and the light-emitting substrate has a good operating state.

The light-emitting substrate, the backlight module and the display apparatus provided by the embodiment of the present disclosure are described by combining the following accompanying drawings.

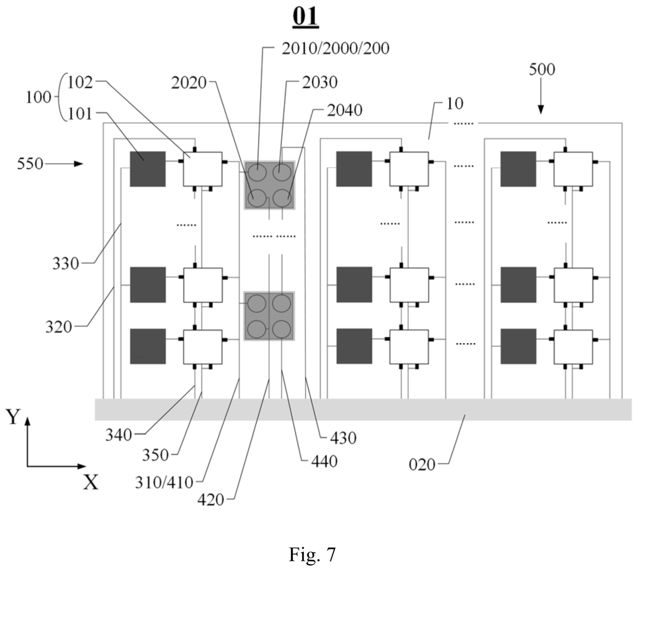

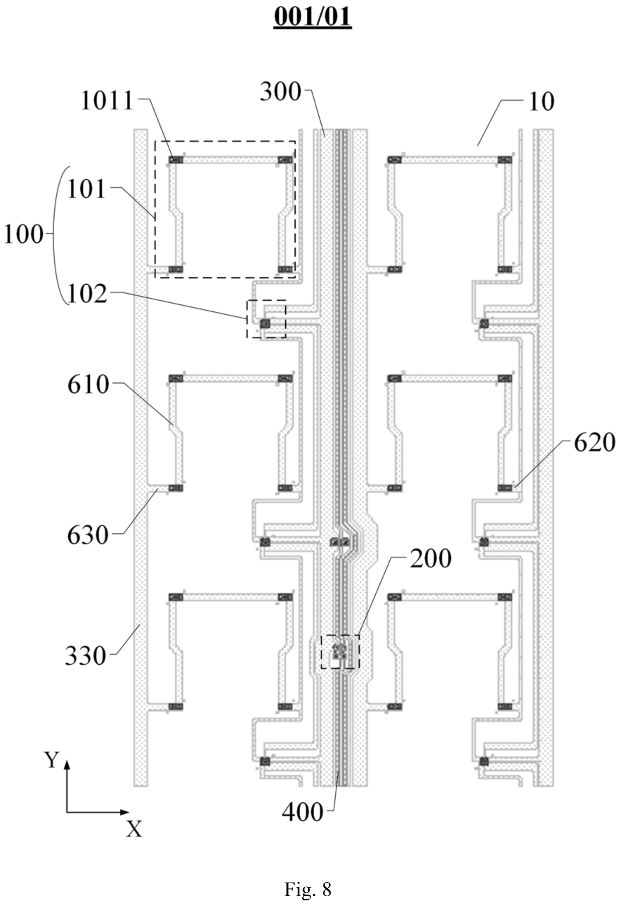

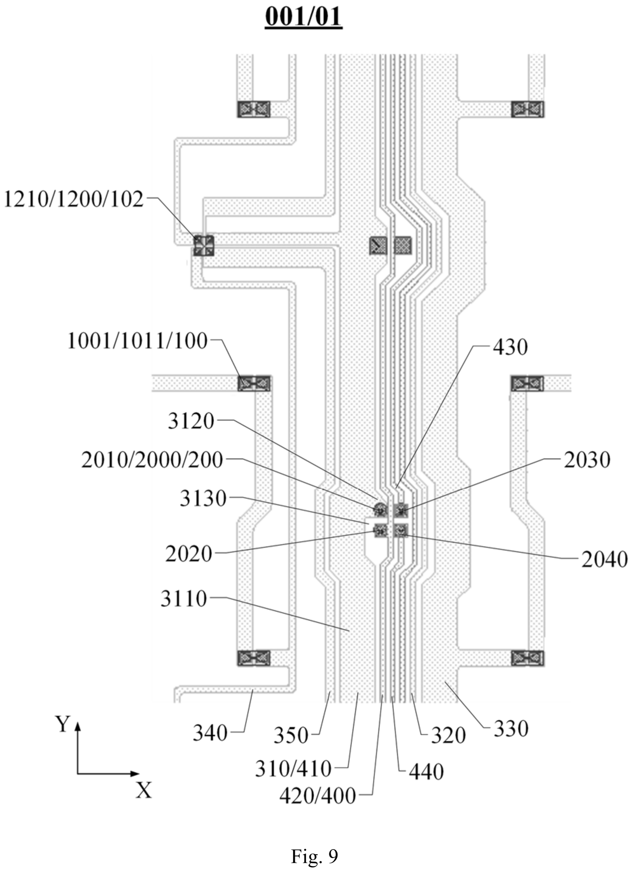

Fig. 7 is a partial structure schematic diagram of a light-emitting substrate provided by at least one embodiment of the present disclosure; Fig. 8 is a partial structure schematic diagram of a conductive pattern layer of the light-emitting substrate in Fig. 7; Fig. 9 is a partial amplification schematic diagram of the conductive pattern layer in Fig. 8.

For example, as shown in Fig. 7, the light-emitting substrate 01 includes a base substrate 10, and a plurality of first drive units 100 located on the base substrate 10. The plurality of first drive units 100 are arranged in an array mode in the first direction X and the second direction Y; the first drive unit 100 includes at least one first drive portion 101 and a drive connecting portion 102; and the drive connecting portion 102 is configured to be connected with a drive circuit (not shown in the figure).

For example, as shown in Fig. 8 and Fig. 9, the first drive portion 101 includes at least one drive port portion 1011; and the drive port portion 1011 includes a plurality of drive ports 1001. For example, the light-emitting substrate 01 further includes a light-emitting element (not shown in the figure), the light-emitting element can be connected with the plurality of drive ports 1001 in the drive port portion 1011, the drive circuit transmits a drive signal to the drive port portion 1011 in the first drive portion 101 through the drive connecting portion 102, so that the light-emitting element emits light.

For example, as shown in Fig. 7 and Fig. 8, the first wire 300 extends in the second direction Y and is connected with the first drive unit 100, and the plurality of first wires 300 and the plurality of first drive units 100 are located in the same conductive pattern layer 001. For example, the plurality of first wires 300 can include a first wire 300 connected with the first drive portion 101, and a first wire 300 connected with the drive connecting portion 102. For example, the material of the conductive pattern layer 001 can include metal such as copper, which is not limited in the embodiment of the present disclosure. For example, the conductive pattern layer 001 can be of a patterned structure formed through a same procedure. For example, the light-emitting substrate 01 can be provided with a single conductive pattern layer such as a "single-layer copper" structure, and therefore, the structure of the light-emitting substrate 01 can be simplified, and the technological manufacturing process can be simplified.

For example, as shown in Fig. 8, the first drive unit 100 include a plurality of first leads 610, at least one second leads 620 and at least one third leads 630 which are located in the conductive pattern layer 001. For example, the first drive portion 101 of the first drive unit 100 of the light-emitting substrate 01 include four drive port portions 1011, and adjacent drive port portions 1011 are connected through the first lead 610, so that the first drive unit 100 include three first leads 610. The first drive portion 101 is connected with the drive connecting portion 102 through the second lead 620 and are connected with a third scanning line 330 through the third lead 630.

For example, as shown in Fig. 8, the light-emitting elements connected with the drive port portions 1011 in the first drive portion 101 form a "lamp region", the first drive unit 100 can include one first drive portion 101, and the first drive portion 101 is connected with the corresponding drive connecting portion 102, so that the first drive unit 100 is of a type that one drive connecting portion 102 drives one "lamp region".

For example, as shown in Fig. 7 and Fig. 8, the light-emitting substrate 01 further includes a second drive unit 200 located on the base substrate 10. At least a portion of the second drive unit 200 is located between two adjacent first drive units 100 in the first direction X, the second drive unit 200 includes a plurality of connecting ends 2000, and a total number of the connecting ends 2000 in the second drive unit 200 is greater than that of drive ports 1001 in the drive port portion 1011.

For example, as shown in Fig. 7 and Fig. 8, the plurality of first drive units 100 are arranged as a plurality of drive unit columns 500 and a plurality of drive unit rows 550 in the first direction X and the second direction Y. At least a portion of the second drive unit 200 is located between two adjacent first drive unit columns 500 in the first direction X. For example, the first drive portions 101 can include a plurality of drive port portions 1011, the total number of the drive port portions 1011 corresponds to the total number of the light-emitting elements one by one, and the light-emitting elements can be connected with a plurality of drive ports 1001 in the drive port portions 1011. For example, the light-emitting element can include two pins with different polarities, such as a positive pin and a negative pin. The drive port portion 1011 can include two drive ports 1001 (as shown in Fig. 9) with opposite polarities, such as the drive port 1001 connected with the positive pin, and the drive port 1001 connected with the negative pin.

For example, as shown in Fig. 7, the second drive unit 200 can include four connecting ends 2000, such as a first connecting end 2010, a second connecting end 2020, a third connecting end 2030 and a fourth connecting end 2040. For example, the light-emitting substrate further includes a sensor (such as a temperature sensor), and the sensor is connected with the plurality of connecting ends 2000 (such as the four connecting ends 2000) in the second drive unit 200 and is configured to monitor the temperature of the light-emitting substrate 01.

For example, as shown in Fig. 7, the sensor can include four different pins which are connected with the first connecting end 2010, the second connecting end 2020, the third connecting end 2030 and the fourth connecting end 2040 respectively. Definitely, the number of the connecting ends 2000 in the second drive unit 200 is not limited in the embodiment of the present disclosure, for example, the number of the connecting ends 2000 in the second drive unit 200 can be determined according to the number of the pins of a matched external monitoring device. For example, the number of the connecting ends 2000 in the second drive unit 200 can be larger than or equal to the number of the pins of the matched external monitoring device on the premise that the external monitoring device can be driven to work normally.

For example, the sensor can quickly and effectively monitor the light-emitting condition of surrounding light-emitting elements so as to adjust various parameters such as current, voltage and brightness of the light-emitting elements in time, thereby ensuring the performance stability of each light-emitting element. For example, the sensor can be divided into multiple types according to its functions, for example, the sensor can be a temperature sensor for detecting the temperature of the surrounding light-emitting elements so as to adjust the parameters such as voltage and current, and a phenomena that the system is insensitive because of too high temperature or the circuit is burnt out because of too high voltage and current can be avoided. For example, the sensor can further be a photosensitive sensor for detecting the brightness of the surrounding light-emitting elements so as to adjust the brightness of each light-emitting element in time, so that the light-emitting brightness of the light-emitting elements is consistent. For example, the sensor can further be an integrated sensor integrated on a chip and is bound on the light-emitting substrate through the second drive unit, the embodiment of the present disclosure does not limit the type of the sensor.

As shown in Fig. 7 and Fig. 8, the first drive unit 100 and the first wire 300 in the light-emitting substrate 01 provided by the embodiment of the present disclosure are located in the same conductive pattern layer 001, so that the light-emitting substrate 01 has a single conductive pattern layer such as a "single-layer copper" structure; the light-emitting substrate 01 is further provided with the second drive unit 200, and the number of the connecting ends 2000 in the second drive unit 200 is larger than that of the drive ports 1001 (as shown in Fig. 9) in the drive port portion 1011, so that the external monitoring device (such as the temperature sensor) can be connected through the plurality of connecting ends 2000, the temperature state of the light-emitting substrate 01 can be monitored, and the light-emitting substrate 01 can have a good running state.

As shown in Fig. 8 and Fig. 9, the second drive unit 200 and the first drive unit 100 are located in the same conductive pattern layer 001, that is, the second drive unit 200 and the first drive unit 100 can be formed through the same patterning process. In this way, the external monitoring device can be arranged, moreover, the structure of the light-emitting substrate 01 is simple, and the manufacturing process can be simplified.

For example, as shown in Fig. 8 and Fig. 9, the light-emitting substrate 01 further includes a plurality of second wires 400; the second wire 400 extends in the second direction Y and is connected with one of the plurality of connecting ends 2000 of the second drive unit 200. For example, as shown in Fig. 7 and Fig. 9, the second wire 400 is located between two adjacent drive unit columns 500 in the first direction X so as to be connected with the second drive unit 200. For example, the first wire 300 and the second wire 400 can be located in the same conductive pattern layer 001, so that the structure of the light-emitting substrate 01 can be further simplified, and the manufacturing process can be further simplified.

For example, as shown in Fig. 9, the plurality of first wires 300 include a first scanning line 310 and a second scanning line 320; the first scanning line 310 and the second scanning line 320 which are the smallest in distance in the first direction X are located between two adjacent first drive units 100, the first scanning line 310 is connected with one of the two first drive units 100, and the second scanning line 320 is connected with the other one of the two first drive units 100.

For example, as shown in Fig. 9, no other first wire 300 is arranged between the first scanning line 310 and the second scanning line 320 which are the smallest in distance in the first direction X. The first scanning line 310 is connected with its adjacent first drive unit 100, and the second scanning line 320 is connected with its adjacent first drive unit 100. For example, the first scanning line 310 is connected with one drive connecting end 1200 in the drive connecting portion 102 of the first drive unit 100, and the second scanning line 320 is connected with the other drive connecting end 1200 in the drive connecting portion 102 of the first drive unit 100.

For example, as shown in Fig. 9, at least a portion of the second drive unit 200 is located between the first scanning line 310 and the second scanning line 320 which are the smallest in distance in the first direction X. For example, in the first direction X, the first scanning line 310 and the second scanning line 320 located between adjacent first drive units 100 have a certain interval, for example, at least one connecting end 2000 of the second drive unit 200 is located in the interval. For example, the second connecting end 2020, the third connecting end 2030 and the fourth connecting end 2040 of the second drive unit 200 are located in the interval, but the embodiment of the present disclosure is not limited to this. For example, in some embodiments, all the connecting ends 2000 of the second drive unit 200 can be located in the interval.

Through the above arrangement, the layout space between the first scanning line 310 and the second scanning line 320 which are the smallest in distance in the first direction X can be effectively utilized, the influence of the arrangement of the second drive unit 200 on the first drive unit 100 is reduced as much as possible, for example, the connecting mode and the structural design of the first drive unit 100 can be reserved to the maximum extent, and therefore the design cost can be reduced.

For example, as shown in Fig. 9, the plurality of second wires 400 include a first signal line 410, a second signal line 420, a third signal line 430 and a fourth signal line 440. For example, in the first direction X, the second signal line 420, the third signal line 430 and the fourth signal line 440 are all located between the first scanning line 310 and the second scanning line 320 which are the smallest in distance, but the embodiment of the present disclosure is not limited to this. For example, in some embodiments, the first signal line 410, the second signal line 420, the third signal line 430 and the fourth signal line 440 can all be located between the first scanning line 310 and the second scanning line 320 which are the smallest in distance in the first direction X.

For example, as shown in Fig. 9, the first signal line 410 is connected with the first connecting end 2010 of the second drive unit 200 and configured to transmit a first common voltage signal, for example, the first common voltage signal can be a grounding signal. The second signal line 420 is connected with the second connecting end 2020 of the second drive unit 200 and configured to transmit a first power signal. The third signal line 430 is connected with the third connecting end 2030 of the second drive unit 200 and configured to transmit a first input signal. The fourth signal line 440 is connected with the fourth connecting end 2040 of the second drive unit 200 and configured to transmit a first output signal.

For example, as shown in Fig. 9, the second wire 400 and the first wire 300 all extend in the second direction Y, through this arrangement, the layout space between the first scanning line 310 and the second scanning line 320 which are the smallest in distance in the first direction X can be effectively utilized, and each connecting end 2000 of the second drive unit 200 can be connected with the corresponding second wire 400, so that the layout arrangement mode of the light-emitting substrate 01 is more reasonable.

For example, as shown in Fig. 9, the first scanning line 310 and the first signal line 410 are of an integrated structure. For example, the first scanning line 310 adjacent to the second drive unit 200 is multiplexed as the first signal line 410, so that the layout space can be saved, and the utilization rate of the layout space can be improved.

For example, as shown in Fig. 9, the first scanning line 310 include a main body portion 3110 and a protruding portion 3120; the main body portion 3110 extends in the second direction Y, the protruding portion 3120 protrudes relative to the main body portion 3110 in the first direction X, and the protruding portion 3120 and the first connecting end 2010 of the second drive unit 200 are of an integrated structure.

For example, as shown in Fig. 9, at least a portion of the protruding portion 3120 is multiplexed as the first connecting end 2010 of the second drive unit 200, so that no extra lead needs to be arranged for connecting the first connecting end 2010 and the first scanning line 310, no layout space needs to be independently reserved for the first connecting end 2010, and the utilization rate of the layout space is effectively improved.

For example, as shown in Fig. 9, in the first direction X, a protruding size of the protruding portion 3120 of the first scanning line 310 relative to the main body portion 3110 is not smaller than the size of the first connecting end 2010. Moreover, the protruding portion 3120 and the main body portion 3110 form a concave cavity 3130, the second connecting end 2020 of the second drive unit 200 are located in the concave cavity 3130, and the second connecting end 2020 and the first scanning line 310 are arranged at intervals, so that the risk of crosstalk is reduced.

For example, as shown in Fig. 9, the second connecting end 2020, the third connecting end 2030 and the fourth connecting end 2040 of the second drive unit 200 are all located between the first scanning line 310 and the second scanning line 320 which are the smallest in distance in the first direction X, so that the utilization rate of the layout space is increased.

For example, in some embodiments of the present disclosure, referring to Fig. 9, the first connecting end 2010 of the second drive unit 200 can also be spaced from the first scanning line 310, and the first connecting end 2010, the second connecting end 2020, the third connecting end 2030 and the fourth connecting end 2040 of the second drive unit 200 can further be located between the first scanning line 310 and the second scanning line 320 which are the smallest in distance in the first direction X.

For example, as shown in Fig. 9, the first connecting end 2010, the second connecting end 2020, the third connecting end 2030 and the fourth connecting end 2040 of the second drive unit 200 are arranged in an array mode with two rows and two columns in the first direction X and the second direction Y, the second connecting end 2020 and the fourth connecting end 2040 are adjacent to each other in the first direction X, and the first connecting end 2010 and the second connecting end 2020 are adjacent to each other in the second direction Y. As shown in Fig. 9, the first connecting end 2010 is located on the side, away from the second scanning line 320, of the third connecting end 2030, and the second connecting end 2020 is located on the side, away from the second scanning line 320, of the fourth connecting end 2040, so that the first connecting end 2010 is connected with the first signal line 410, and the second connecting end 2020 is connected with the second signal line 420.

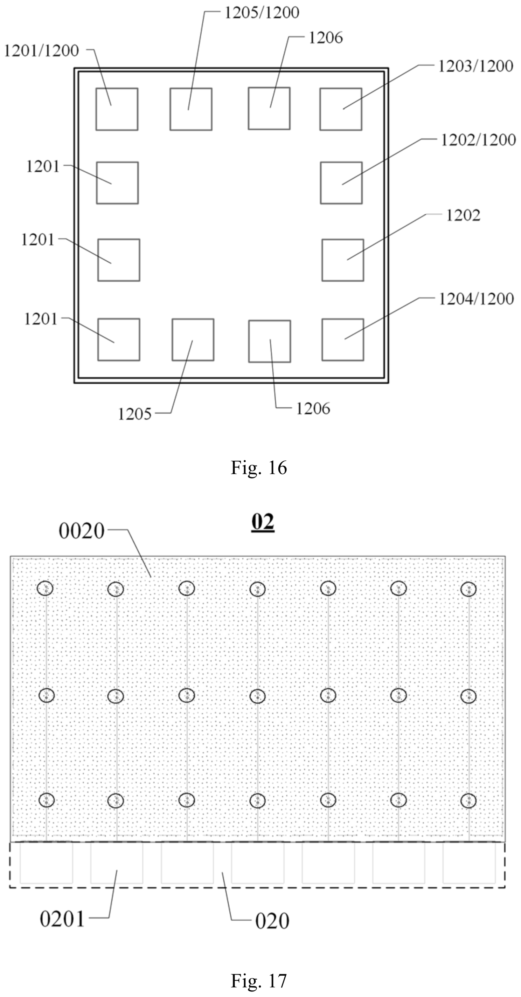

For example, as shown in Fig. 9, in the second drive units 200 located in the same column in the second direction Y, the third connecting end 2030 of the second drive unit 200 located in the N^{th} row is located on the side, away from the second drive unit 200 located in the (N+1)^{th} row, of the fourth connecting end 2040 of the second drive unit 200 located in the N^{th} row, and N is a positive integer. For example, the fourth connecting end 2040 of the second drive unit 200 located in the N^{th} row can be connected with the third connecting end 2030 of the second drive unit 200 located in the (N+1)^{th} row through the fourth signal line 440, that is, the fourth connecting end 2040 of the second drive unit 200 can be connected with the third connecting end 2030 of the adjacent second drive unit 200 through the fourth signal line 440. The third connecting end 2030 of the second drive unit 200 located in the first row is connected with a bonding region (please referring to Fig. 17) through the third signal line 430 so as to receive the first input signal. The fourth connecting end 2040 of the second drive unit 200 located in the last row is connected with the bonding region through the fourth signal line 440, and the fourth signal line 440 is configured to transmit the first output signal.

For example, as shown in Fig. 6 and Fig. 9, the first connecting end 2010, the second connecting end 2020, the fourth connecting end 2040 and the third connecting end 2030 of the second drive unit 200 are sequentially arranged at intervals in a circumferential direction, so that the plurality of connecting ends 2000 with this arrangement mode can be used in the light-emitting substrate 014 which is of a "double-layer copper" structure and can also be multiplexed in the light-emitting substrate 01 with a single conductive pattern layer such as a "single-layer copper" structure.

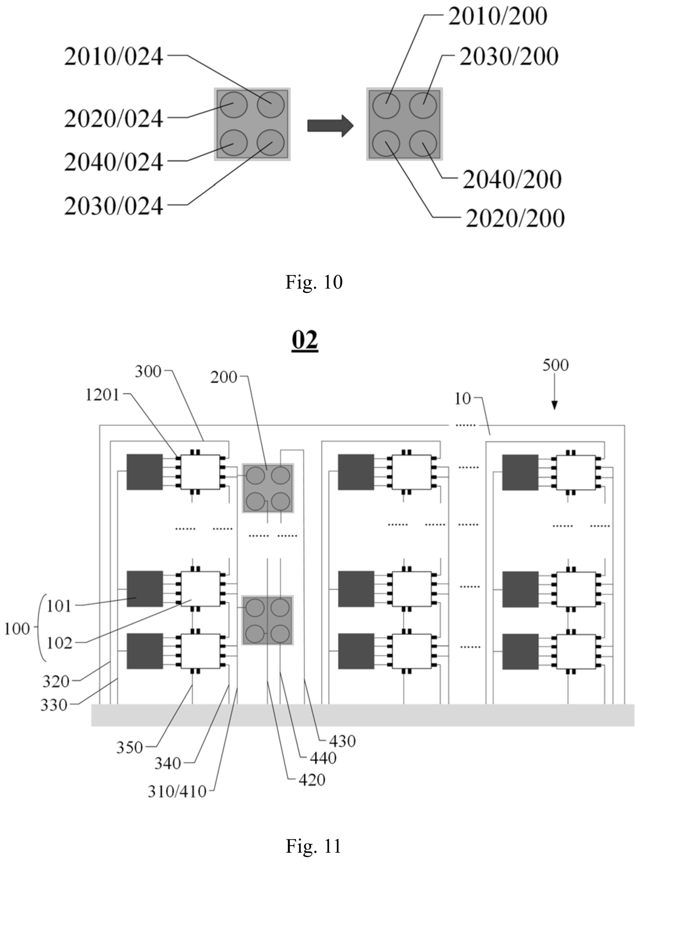

Fig. 10 is a partial schematic diagram of a second drive unit corresponding to the light-emitting substrate in Fig. 6 and Fig. 7.

For example, as shown in Fig. 10, the four connecting ends 024 of the light-emitting substrate 014 in Fig. 6 are rotated by 90°anticlockwise and then can be used as the four connecting ends of the second drive unit 200 of the light-emitting substrate 01 in Fig. 7. Therefore, the design cost of the second drive unit 200 of the light-emitting substrate 01 with the single conductive pattern layer such as the "single-layer copper" structure can be reduced.

For example, as shown in Fig. 9, the second connecting ends 2020 of second drive units 200 located in the same column are connected with the same second signal line 420, and the same second signal line 420 is located between the first connecting end 2010 and the third connecting end 2030 in the first direction X. For example, the second connecting ends 2020 of the second drive units 200 located in the same column receive the first power signal from the same second signal line 420 at the same time. For example, the second signal line 420 is insulated from the first connecting end 2010, the third connecting end 2030 and the fourth connecting end 2040 and are arranged at intervals. The second signal line 420 is located between the first connecting end 2010 and the third connecting end 2030 in the first direction X and is located between the second connecting end 2020 and the fourth connecting end 2040 in the first direction X, so that the utilization rate of the layout space is improved, and the layout arrangement is more compact.

For example, as shown in Fig. 9, the drive connecting portion 102 of the first drive unit 100 and the second drive unit 200 are arranged at intervals in the first direction X and are arranged at intervals in the second direction Y. For example, the drive connecting portion 102 of the first drive unit 100 and the second drive unit 200 have a first spacing distance in the first direction X, and the drive connecting portion 102 of the first drive unit 100 and the second drive unit 200 have a second spacing distance in the second direction Y. For example, the first spacing distance is smaller than the second spacing distance, but the embodiment of the present disclosure is not limited to this. Through this arrangement, the risk of signal crosstalk between the drive connecting portion 102 of the first drive unit 100 and the second drive unit 200 can be reduced, and the drive connecting portion 102 of the first drive unit 100 and the second drive unit 200 can be distributed in a staggered mode, so that the layout space is reasonably utilized.

For example, as shown in Fig. 9, the first drive unit 100 and the second drive unit 200 are arranged at an interval in a first direction X to reserve a certain layout space, which facilitates the arrangement of at least a portion of the first wire 300 (for example, at least a portion of the first scanning line 310 and at least a portion of the fifth scanning line 350).

For example, in some embodiments of the present disclosure, referring to Fig. 9, the first drive unit 100 and the second drive unit 200 can also be arranged at intervals in the second direction Y, and the first drive unit 100 and the second drive unit 200 are not overlapped in the first direction X, so that signal interference between the first drive unit 100 and the second drive unit 200 is reduced, and the layout space can be utilized more reasonably.

For example, as shown in Fig. 8 and Fig. 9, the drive connecting portion 102 in the first drive unit 100 include a plurality of drive connecting ends 1200, and the light-emitting element is connected with the plurality of drive connecting ends 1200 of the drive connecting portion 102. For example, the first drive unit 100 of the light-emitting substrate 01 include a first drive portion 101, and the first drive portion 101 is connected with one of the plurality of drive connecting ends 1200 (for example, a drive connecting end 1210). Therefore, the first drive portions 101 in the first drive unit 100 are in one-to-one correspondence with the drive connecting portions 102, and one drive connecting portion 102 transmits a drive signal to one first drive portion 101 to drive the light-emitting element to emit light.

For example, as shown in Fig. 7 and Fig. 9, the plurality of first wires 300 further include a third scanning line 330, a fourth scanning line 340 and a fifth scanning line 350. For example, in the first direction X, the second scanning line 320, the third scanning line 330, the fourth scanning line 340, the fifth scanning line 350 and the first scanning line 310 connected with the first drive unit 100 are sequentially arranged, and the first drive portion 101 is located between the third scanning line 330 and the fourth scanning line 340.

For example, as shown in Fig. 7 and Fig. 9, the first scanning line 310 is configured to transmit a second common voltage signal, such as a grounding signal. The first drive units 100 located in the same drive unit column 500 are all connected with the same first scanning line 310, and one end of each first scanning line 310 is connected with the bonding region 020. For example, one drive connecting end 1200 of the drive connecting portion 102 of the first drive unit 100 located in the first row in the drive unit column 500 is connected with the second scanning line 320, and the second scanning line 320 is configured to transmit a second input signal. One end of the second scanning line 320 is connected with the bonding region 020. For example, the first drive portions 101 of the first drive units 100 located in the same drive unit column 500 are all connected with the same third scanning line 330, and the third scanning line 330 is configured to transmit a third power signal to the first drive portion 101. One end of the third scanning line 330 is connected with the bonding region 020.

For example, as shown in Fig. 7 and Fig. 9, in the same drive unit column 500, one drive connecting end 1200 of the drive connecting portion 102 of the first drive unit 100 located in the N^{th} row is connected with one drive connecting end 1200 of the drive connecting portion 102 of the first drive unit 100 located in the (N+1)^{th} row through the fourth scanning line 340, so that the drive connecting portion 102 of the first drive unit 100 located in the N^{th} row is connected with the drive connecting portion 102 of the first drive unit 100 located in the (N+1)^{th} row in series. One drive connecting end 1200 of the drive connecting portion 102 of the first drive unit 100 located in the last row is connected with the bonding region 020 through the fourth scanning lines 340, and the fourth scanning line 340 is configured to transmit the second output signal.

For example, as shown in Fig. 7 and Fig. 9, the drive connecting portions 102 of the first drive units 100 in the same drive unit column 500 are connected with the same fifth scanning line 350, one end of the fifth scanning line 350 is connected with the bonding region 020, and the fifth scanning line 350 is configured to transmit a third output power signal.

For example, as shown in Fig. 7 and Fig. 9, a Flexible Printed Circuit (FPC) is arranged in the bonding region 020, the first wire 300 and the second wire 400 are all connected with the FPC and are connected with a Printed Circuit Board Assembly (PCBA) through the FPC, and thus a signal transmission is achieved.

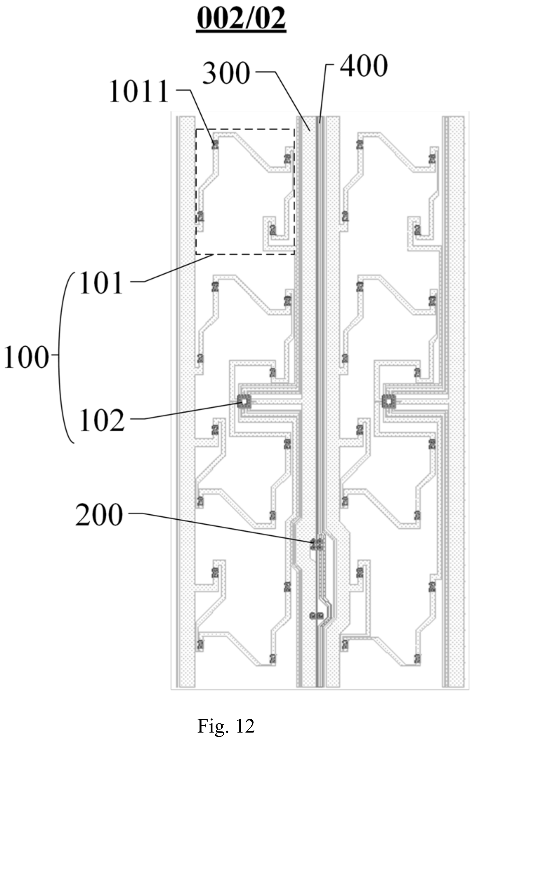

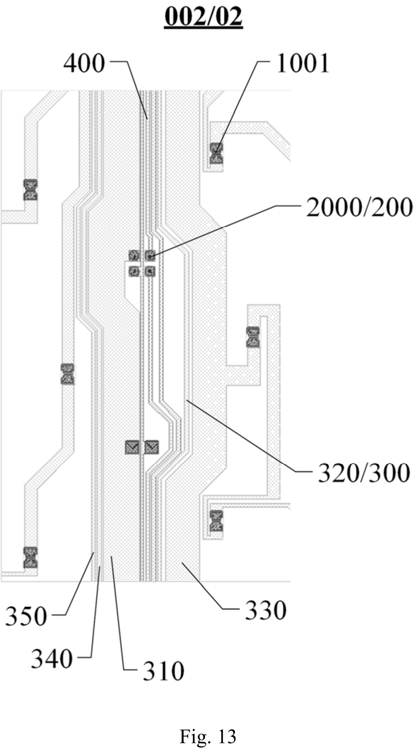

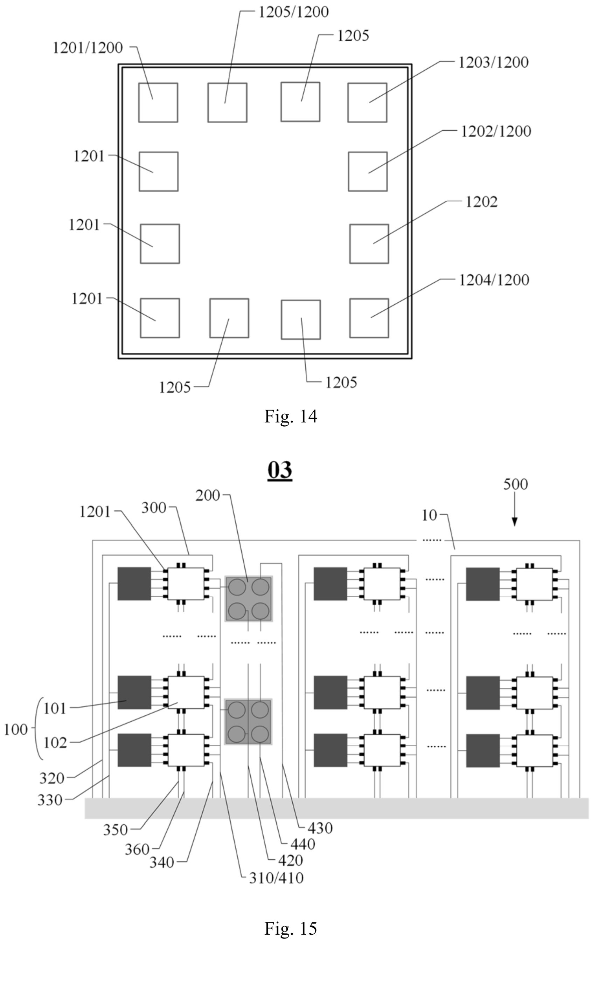

Fig. 11 is a partial structure schematic diagram of another light-emitting substrate provided by at least one embodiment of the present disclosure; Fig. 12 is a partial structure schematic diagram of a conductive pattern layer of the light-emitting substrate in Fig. 11; Fig. 13 is a partial amplification schematic diagram of the conductive pattern layer in Fig. 12; and Fig. 14 is a partial amplification schematic diagram of a second drive unit of the light-emitting substrate in Fig. 11.

For example, as shown in Fig. 11 and Fig. 12, the light-emitting substrate 02 includes a base substrate 10, a plurality of first drive units 100, a plurality of first wires 300, and second drive units 200; and the first drive units 100, the first wires 300 and the second drive units 200 are located on the base substrate 10. The first drive units 100 are arranged in an array mode in a first direction X and a second direction Y, and each first drive unit 100 includes four first drive portions 101 and a drive connecting portion 102. The first drive portion 101 includes four drive port portions 1011, and the drive port portion 1011 includes two drive ports 1001. For example, a light-emitting element can be connected with the two drive ports 1001 of the drive port portion 1011, and the drive connecting portion 102 is configured to transmit a drive signal to the drive port portion 1011 of the first drive unit 100 so as to drive the light-emitting element to emit light.

For example, as shown in Fig. 11 and Fig. 12, the first wire 300 extends in the second direction Y and is connected with the first drive unit 100, and the plurality of first wires 300 and the plurality of first drive units 100 are located in the same conductive pattern layer 002. For example, the material of the conductive pattern layer 002 can include metal such as copper, which is not limited in the embodiment of the present disclosure. For example, the conductive pattern layer 002 can be of a patterned structure formed through the same procedure. For example, the light-emitting substrate 02 can be provided with a single conductive pattern layer such as a "single-layer copper" structure, and therefore the structure of the light-emitting substrate 02 can be simplified, and the technological manufacturing process can be simplified.

For example, as shown in Fig. 11, the light-emitting substrate 02 further includes a second drive unit 200 located on the base substrate 10. At least a portion of the second drive unit 200 is located between two adjacent first drive units 100 in the first direction X, and the second drive unit 200 includes four connecting ends 2000, so that the number of the connecting ends 2000 in the second drive unit 200 is larger than that of drive ports 1001 in the drive port portion 1011.

For example, as shown in Fig. 12 and Fig. 13, one drive connecting portion 102 in the first drive unit 100 transmits drive signals to four first drive portions 101 at the same time so as to drive four light-emitting elements connected with the four first drive portions 101 respectively to emit light. For example, the four light-emitting elements connected with each of the four first drive portions 101 in the first drive unit 100 form a "lamp region", so that one drive connecting portion 102 in each first drive unit 100 drives four "lamp region" at the same time.

For example, as shown in Fig. 12 and Fig. 13, every four "lamp regions" in the first drive unit 100 are sequentially arranged in a column, and two first drive units 100 are located on the two sides of the drive connecting portion 102 in the second direction Y, so that the distribution of the drive signals is more uniform.

For example, in some embodiments of the present disclosure, referring to Fig. 12 and Fig. 13, in the first drive unit 100, one first drive unit 100 can be located on one side of the drive connecting portion 102 in the second direction Y, and three first drive units 100 can be located on the other side of the drive connecting portion 102.

For example, as shown in Fig. 11 and Fig. 14, the drive connecting portion 102 in the first drive unit 100 includes a plurality of drive connecting ends 1200, the first drive unit 100 include four first drive portions 101, the plurality of drive connecting ends 1200 include four driving sub-connecting ends 1201, and the four first drive portions 101 are connected with the four driving sub-connecting ends 1201 in a one-to-one correspondence manner.

For example, as shown in Fig. 11, the plurality of first wires 300 include a first scanning line 310, a second scanning line 320, a third scanning line 330, a fourth scanning line 340 and a fifth scanning line 350. In the first direction X, the second scanning line 320, the third scanning line 330, the fifth scanning line 350, the fourth scanning line 340 and the first scanning line 310 are sequentially arranged. For example, the first drive portion 101 is located between the third scanning line 330 and the fifth scanning line 350.

For example, as shown in Fig. 11 and Fig. 14, the first scanning line 310 is configured to transmit a second common voltage signal, such as a grounding signal. The first drive units 100 in the same drive unit column 500 are connected with the same first scanning line 310, and one end of the first scanning line 310 is connected with the bonding region 020. For example, the drive connecting portion 102 include two common voltage connecting ends 1202, and the two common voltage connecting ends 1202 of the drive connecting portion 102 are connected with the first scanning line 310.

For example, as shown in Fig. 11 and Fig. 14, one drive connecting end 1200 (for example, a drive connecting end 1203) of the drive connecting portion 102 of the first drive unit 100 located in a first row in the drive unit column 500 is connected with the corresponding second scanning line 320, and the second scanning line 320 is configured to transmit a second input signal. One end of the second scanning line 320 is connected with the bonding region 020.

For example, as shown in Fig. 11 and Fig. 14, four first drive portions 101 of the first drive unit 100 located in the same drive unit column 500 are connected with the same third scanning line 330, and the third scanning line 330 is configured to transmit a third power signal to the first drive portion 101. One end of the third scanning line 330 is connected with the bonding region 020.

For example, as shown in Fig. 11 and Fig. 14, in the same drive unit column 500, one drive connecting end 1200 (for example, a drive connecting end 1204) of the drive connecting portion 102 of the first drive unit 100 located in the N^{th} row is connected with one drive connecting end 1200 (for example, a drive connecting portion 1203) of the drive connecting portion 102 of the first drive unit 100 located in an (N+1)^{th} row through the fourth scanning line 340, so that the drive connecting portion 102 of the first drive unit 100 located in the N^{th} row is connected in series with the drive connecting portion 102 of the first drive unit 100 located in the (N+1)^{th} row. One drive connecting end 1200 (for example, a drive connecting portion 1204) of the drive connecting portion 102 of the first drive unit 100 located in the last row is connected with the bonding region 020 through the fourth scanning line 340, and the fourth scanning line 340 is configured to transmit a second output signal.

For example, as shown in Fig. 11 and Fig. 14, the drive connecting portion 102 includes four power supply connecting ends 1205; in the same drive unit column 500, one power supply connecting end 1205 of the drive connecting portion 102 of the first drive unit 100 in the N^{th} row is connected with one power supply connecting end 1205 of the drive connecting portion 102 of the first drive unit 100 in the (N+1)^{th} row, so that the drive connecting portion 102 of the first drive unit 100 in the N^{th} row is connected with the drive connecting portion 102 of the first drive unit 100 in the (N+1)^{th} row in series; one power supply connecting end 1205 of the drive connecting portion 102 of the first drive unit 100 in the last row is connected with the fifth scanning line 350; one end of the fifth scanning line 350 is connected with the binding region 020; and the fifth scanning line 350 is configured to transmit a third output power signal.

For example, as shown in Fig. 11 and Fig. 13, the structure and the arrangement mode of the second drive unit 200 in the light-emitting substrate 02 can refer to the related description of Fig. 7 and Fig. 9 in the above embodiments, which will not be repeated here.

Fig. 15 is a partial structure schematic diagram of yet another light-emitting substrate provided by at least one embodiment of the present disclosure; and Fig. 16 is a partial amplification schematic diagram of a second drive unit of the light-emitting substrate in Fig. 15.

For example, as shown in Fig. 15 and Fig. 16, a light-emitting substrate 03 and the light-emitting substrate 02 in Fig. 11 are different in the second drive unit 200 and the second wire 400, and the other structures are the same; and the other structures can refer to the related description of Fig. 11 and Fig. 13 in the above embodiment, which will not be listed here.

For example, as shown in Fig. 15 and Fig. 16, the drive connecting portion 102 includes two power connecting ends 1205 and two clock signal connecting ends 1206. For example, the display substrate 03 also includes a sixth scanning line 360.

For example, as shown in Fig. 15 and Fig. 16, in the same drive unit column 500, one power connecting end 1205 of the drive connecting portion 102 of the first drive unit 100 located in the N^{th} row is connected with one power connecting end 1205 of the drive connecting portion 102 of the first drive unit 100 located in the (N+1)^{th} row, thereby enabling the drive connecting portion 102 of the first drive unit 100 located in the N^{th} row to be in series connection with the drive connecting portion 102 of the first drive unit 100 located in the (N+1)^{th} row; one power connecting end 1205 of the drive connecting portion 102 of the first drive unit 100 located in the last row is connected with the fifth scanning line 350, and one end of the fifth scanning line 350 is connected with the binding region 020; and the fifth scanning line 350 is configured to transmit a third output power signal.

For example, as shown in Fig. 15 and Fig. 16, in the same drive unit column 500, one clock signal connecting end 1206 of the drive connecting portion 102 of the first drive unit 100 located in the N^{th} row is connected with one clock signal connecting end 1206 of the drive connecting portion 102 of the first drive unit 100 located in the (N+1)^{th} row, thereby enabling the drive connecting portion 102 of the first drive unit 100 located in the N^{th} row to be in series connection with the drive connecting portion 102 of the first drive unit 100 located in the (N+1)^{th} row; one clock signal connecting end 1206 of the drive connecting portion 102 of the first drive unit 100 located in the last row is connected with the sixth scanning line 360, and one end of the sixth scanning line 360 is connected with the binding region 020; and the sixth scanning line 360 is configured to transmit a clock signal.

For example, as shown in Fig. 15 and Fig. 16, the sixth scanning line 360 can also be configured to transmit other signals. For example, in some embodiments, the sixth scanning line 360 can also be configured to transmit a data signal, which is not limited in the embodiment of the present disclosure. For example, in some embodiments, the drive connecting portion 102 can also be provided with other connecting ends to adapt to more signal transmission requirements. For example, the drive connecting portion 102 of the first drive unit 100 can be connected with different scanning lines according to design requirements to transmit different signals, so that the light-emitting substrate has richer signal transmission functions.

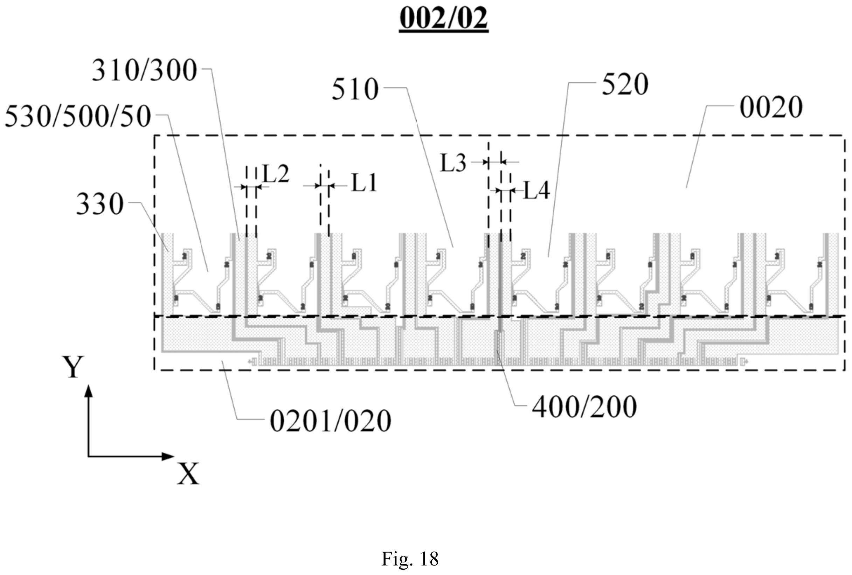

Fig. 17 is an overall structure schematic diagram corresponding to the light-emitting substrate in Fig. 13; and Fig. 18 is a partial cross-section schematic diagram corresponding to the light-emitting substrate in Fig. 13.

For example, as shown in Fig. 13 and Fig. 17, the light-emitting substrate 02 includes a display portion 0020, and the bonding region 020 located on one side of the display portion 0020 in the second direction Y. For example, the display portion 0020 is configured to display, and the plurality of first wires 300 and the plurality of second wires 400 in the light-emitting substrate 02 extend into the bonding region 020.

For example, as shown in Fig. 17 and Fig. 18, the bonding region 020 includes a plurality of binding sub-regions 0201, the light-emitting substrate 01 includes a plurality of drive groups 50, each drive group 50 includes a plurality of drive unit columns 500 which are sequentially arranged in the first direction X, and each drive unit column 500 includes at least one first drive unit 100. For example, in Fig. 18, it is described by taking the drive group 50 including eight drive unit columns 500 as an example, but the number of the drive unit columns 500 in the drive group 50 is not limited in the embodiments of the present disclosure.

For example, as shown in Fig. 18, the first wire 300 connected with the first drive unit 100 in the drive group 50 extends to the binding sub-region 0201, at least one second drive unit 200 is arranged in the drive group 50, and the second wire 400 connected with the second drive unit 200 extends to the binding sub-region 0201. For example, the structure and the arrangement mode of the second drive unit 200 in the drive group 50 can refer to relevant description of Fig. 13 in the embodiment, which will not be listed here. For example, the plurality of binding sub-regions 0201 in the light-emitting substrate 02 are independent of one another and can be independently controlled. For example, the first wires 300 located in different binding sub-regions 0201 can have different control states, and for example, signal transmission can be carried out at different times. For example, the second wires 400 located in the different binding sub-regions 0201 can also have different control states, and for example, signal transmission can be carried out at different times, which is not limited in the embodiment of the present disclosure.

For example, as shown in Fig. 18, a column of second drive units 200 is arranged in the drive group 50, and the number of the drive unit rows 500, located on the two sides of the second drive unit 200, in the drive group 50 is equal in the first direction X. For example, the number of the drive unit rows 500 in the drive group 50 can be an even number, and therefore the second drive unit 200 can be located in the middle portion of the drive group 50. For example, in response to that the second drive unit 200 is electrically connected with a temperature sensor, the temperature sensor can be arranged in the middle portion of the drive group 50, and therefore the temperature state of all portions of the drive group 50 can be well monitored.

Definitely, in some embodiments of the present disclosure, referring to Fig. 18, the number of the drive unit columns 500, located on both sides of the second drive unit 200, of the drive group 50 may be unequal in the first direction X. For example, 3 drive unit columns 500 may be located on one side of the second drive unit 200 in the drive group 50, and 5 drive unit columns 500 may be located on the other side of the second drive unit 200 in the drive group 50, so that the temperature detection requirements for different regions of the drive group 50 can be met.

For example, as shown in Fig. 18, the plurality of drive unit columns 500 in the drive group 50 may include a first drive unit column 510, a second drive unit column 520, and a plurality of third drive unit columns 530. The first drive unit column 510 and the second drive unit column 520 are disposed adjacent to each other in the first direction X, at least one third drive unit column 530 is located on the side, away from the second drive unit column 520, of the first drive unit column 510, and at least one third drive unit column 530 is located on the side, away from a first drive unit column 510, of the second drive unit column 520. For example, no other drive unit column 500 is disposed between the first drive unit column 510 and the second drive unit column 520, that is, the first drive unit column 510 and the second drive unit column 520 are disposed adjacent to each other in the first direction X. For example, in the first direction X, the third drive unit columns 530 are disposed on both the side, away from the second drive unit column 520, of the first drive unit column 510 and the side, away from the first drive unit column 510, of the second drive unit column 520.

For example, as shown in Fig. 18, at least a portion of second drive unit 200 is located between the first drive unit column 510 and the second drive unit column 520, and the number of drive unit columns 500 in the drive group 50 is an even number. For example, in the first direction X, the first drive unit column 510, at least a portion of the second drive unit 200 and the second drive unit column 520 are sequentially arranged.

For example, as shown in Fig. 18, a column of second drive units 200 are arranged in the drive group 50, and in the first direction X, the number of third drive unit columns 530, located on the two sides of the second drive unit 200, in the drive group 50 is equal, namely, the number of the third drive unit columns 530 is 3, which is not limited in the embodiment of the present disclosure.

For example, referring to Fig. 18, in some designs, in response to that the relative positions of the second drive units 500 in the plurality of drive group 50 are different, in order to meet a batch production requirement in the actual production process, the binding sub-region 0201 need to be provided with a plurality of connecting regions, and therefore at least one connecting region, corresponding to the second drive unit 200, in the binding sub-region 0201 can be vacant, resulting in waste of layout space and increase of manufacturing cost.

Therefore, in the embodiment of the present disclosure, as shown in Fig. 18, the second wire 400 connected with the second drive unit 200 in the drive group 50 extend to the middle portion of the binding sub-region 0201. For example, the first wires 300 located on the two sides of the second wire 400 in the binding sub-region 0201 are approximately symmetrically distributed, which facilitates the arrangement of the plurality of first wires 300. For example, as the relative positions of the second drive units 200 in the drive group 50 are basically the fixed, for example, the second drive units 200 are located in the middle portion of the drive group 50.

As shown in Fig. 18, in this arrangement, the position of binding sub-region 0201 corresponding to a connecting region of the second drive unit 200 is basically fixed, so that each binding sub-region 0201 has structural uniformity, which facilitates the implementation of a common solution; and the size of the binding sub-region 0201 in the first direction X is relatively small, so that the layout design of the binding sub-region 0201 is compact and reasonable.

For example, as shown in Fig. 13 and Fig. 18, in the first direction X, the width of the second scanning line 320, the width of the fourth scanning line 340 and the width of the fifth scanning line 350 are all smaller than the width of the first scanning line 310 and smaller than the width of the third scanning line 330. For example, in the embodiment of the present disclosure, the width of each scanning line (or each signal line) represents the average width of the portion, extending in the second direction Y, of the scanning line (or the signal line). The width of the first scanning line 310 and the width of the third scanning line 330 are both relatively large, so that the resistance of the first scanning line 310 and the third scanning line 330 is reduced, and signal transmission is facilitated.

For example, as shown in Fig. 13 and Fig. 18, the first scanning lines 310 connected with the first drive units 100 in all the third drive unit columns 530 have the same width which is a first width L1. The third scanning lines 330 connected with the first drive units 100 in all the third drive unit columns 530 have the same width which is a second width L2, and the first width L1 and the second width L2 are approximately equal. For example, the first width L1 of the first scanning line 310 and the second width L2 of the third scanning line 330 can be 1.0 mm to 1.5 mm, for example, at least one of 1.0 mm to 1.3 mm, 1.1 mm to 1.2 mm, 1.2 mm to 1.4 mm, 1.3 mm to 1.4 mm and 1.2 mm to 1.5 mm, which is not limited in the embodiment of the present disclosure. The first width L1 and the second width L2 are approximately equal, so the design difficulty of the first scanning line 310 and the third scanning line 330 connected with the first drive units 100 in the third drive unit column 530 is reduced, and the manufacturing process is simplified.

For example, as shown in Fig. 13 and Fig. 18, the width of the first scanning line 310 connected with the first drive units 100 in the first drive unit column 510 is a third width L3, and the third width L3 is smaller than the first width L1. The width of the third scanning line 330 connected with the first drive units 100 in the second drive unit column 520 is a fourth width L4, and the fourth width L4 is smaller than the second width L2.

For example, as shown in Fig. 13 and Fig. 18, the third width L3 and the fourth width L4 can be approximately equal, for example, both can be 0.8 mm to 1.2 mm, for example, at least one of 0.8 mm to 1.0 mm, 0.9 mm to 1.1 mm, 0.95 mm to 1.1 mm and 1.0 mm to 1.1 mm, which is not limited in the embodiment of the present disclosure.

The third width L3 of the first scanning line 310 connected with the first drive units 100 in the first drive unit column 510 is smaller than the first width L1 of the first scanning line 310 connected with the first drive units 100 in the third drive unit column 530, and the fourth width L4 of the third scanning line 330 connected with the first drive units 100 in the second drive unit column 520 is smaller than the second width L2 of the third scanning line 330 connected with the first drive units 100 in the third drive unit column 530, so that the layout space can be reduced, the arrangement of the second drive unit 200 is facilitated, and the layout arrangement is more reasonable.

For example, as shown in Fig. 13 and Fig. 18, the third width L3 can be 80% to 90% of the first width L1, for example, at least one of 80% to 85%, 82% to 87%, 83% to 86%, 84% to 88% and 85% to 89%, which is not limited in the embodiment of the present disclosure. For example, the fourth width L4 can be 80% to 90% of the second width L2, for example, at least one of 80% to 85%, 82% to 87%, 83% to 86%, 84% to 88% and 85% to 89%, which is not limited in the embodiment of the present disclosure. For example, the first width L1 and the second width L2 can be 1.1 mm, the third width L3 and the fourth width L4 can be 0.95 mm, which is not limited in the embodiment of the present disclosure.

According to the above arrangement, the width (third width L3) of the first scanning line 310 connected with the first drive units 100 of the first drive unit column 510 adjacent to the second drive unit 200, and the width (fourth width L4) of the third scanning line 330 connected with the first drive units 100 of the second drive unit column 520 may be affected, and the influence on the width of the first wire 300 connected with the first drive units 100 of the third drive unit column 530 of the drive group 50 is small, and for example, the resistance cannot be increased because of the reduction of the width of the first wire 300 connected with the first drive units 100 of the third drive unit column 530, and therefore the thickness of the first wire 300 cannot be increased in order to reduce the resistance.

For example, as shown in Fig. 18, the average length of the portions, extending to the binding sub-region 0201, of the first wires 300 (for example, the first scanning line 310 and the third scanning line 330) connected with the first drive units 100 of the drive unit column 500 that are closer to the middle portion of the drive group 50 is smaller, and thus IR drop can be smaller; and conversely, the average length of the portions, extending to the binding sub-region 0201, of the first wires 300 connected with the first drive units 100 of the drive unit column 500 that are farther away from the middle portion of the drive group 50 are larger, and thus IR drop will be larger.

Therefore, as shown in Fig. 18, in response to that the second wire 400 connected with the second drive unit 200 in the drive group 50 extends to the middle portion of the binding sub-region 0201, the width of the first wire 300 connected with the first drive units 100 in the third drive unit column 530 cannot be reduced because of the arrangement of the second drive unit 200, so that the third drive unit columns 530 in the drive group 50 have higher structural uniformity, the process manufacturing flow is simplified, the IR drop of the first wire 300 connected with the first drive units 100 in the third drive unit column 530 is reduced, the heat productivity of the first wire 300 during working is reduced, and good electrical characteristics are achieved. Moreover, the portion, extending to the binding sub-region 0201, of the second wire 400 connected with the second drive unit 200 is basically vertical, so that the length of the portion in the second direction Y can be reduced, the resistance is reduced, the IR drop of the second wire 400 is reduced, the heat productivity of the second wire 400 during working is reduced, and good electrical characteristics are achieved.

For example, as shown in Fig. 18, the average length of the portions, extending into the binding sub-region 0201, of the first wires 300 connected with the first drive units 100 in the first drive unit column 510 is a first length H1. The average length of the portions, extending into the binding sub-region 0201, of the second wires 400 connected with the second drive units 200 is a second length H2, and the second length H2 is smaller than the first length H1.

For example, as shown in Fig. 18, the first drive units 100 in the first drive unit column 510 are connected with the plurality of first wires 300, such as the first scanning line 310, the second scanning line 320, the third scanning line 330, the fourth scanning line 340 and the fifth scanning line 350 as shown in Fig. 11. In order to facilitate layout space arrangement, the portion, extending into the binding sub-region 0201, of the first wire 330 is provided with a bent portion, and therefore the first length H1 of the portion, extending into the binding sub-region 0201, of the first wire 330 is large.

For example, as shown in Fig. 18, the second drive unit 200 is connected with the plurality of second wires 400, such as the first signal line 410, the second signal line 420, the third signal line 430 and the fourth signal line 440 as shown in Fig. 11. For example, because the portion, extending into the binding sub-region 0201, of the second wire 400 is basically vertical, the second length H2 of the portion, extending into the binding sub-region 0201, of the second wire 400 is small, and the second length H2 is smaller than the first length H1.

For example, as shown in Fig. 11 and Fig. 18, the average length of a plurality of portions, extending to the binding sub-region 0201, of the plurality of second wires 400 is a second length H2, and the length of the portion, extending to the binding sub-region 0201, of the third scanning line 330 connected with the first drive units 100 in the first drive unit column 510 is larger than the second length H2.

According to the above arrangement, the resistance of the second wire 400 can be reduced, heat generated by the second wire 400 during work is reduced, the safety performance can be improved, the manufacturing cost can be reduced, and the influence on IR drop of the whole light-emitting substrate is small.

At least one embodiment of the present disclosure also provides a backlight module including the light-emitting substrate described in any one of the above embodiments. The other structures and functions of the backlight module provided by the embodiment of the present disclosure can be implemented with reference to conventional technology, which will not be limited in the embodiment of the present disclosure. The technical effect of the backlight module provided by the embodiment of the present disclosure can refer to the above description of the technical effect of the light-emitting substrate provided by the embodiment of the present disclosure, which will not be listed here.

At least one embodiment of the present disclosure also provides a display apparatus including the backlight module provided by the embodiment of the present disclosure, and the display module arranged on one side of the backlight module. For example, the backlight module can provide backlight for the display module. Because the display module includes the light-emitting substrate in any one of the above embodiments, it also has the technical effects brought by the aforementioned light-emitting substrate, which will not be listed here.

For example, the display apparatus can be a TV set, a notebook computer, a tablet computer, a wearable display device, a mobile phone, a vehicle display, a GPS, an e-book, a digital photo frame, an advertising light box and other products or components with display functions, which are not limited by the embodiment of the present disclosure.

There are the following points to be clarified:
(1) The accompanying drawings of the embodiments of the present disclosure relate only to the structures involved with the embodiments of the present disclosure, and other structures can be referred to the usual design.
(2) Features in the same embodiment and different embodiments of the present disclosure may be combined with each other without conflict.

The foregoing is only an exemplary embodiment of the present disclosure and is not intended to limit the scope of protection of the present disclosure, which is determined by the appended rights.

## Claims

1. A light-emitting substrate, comprising:
a base substrate;
a plurality of first drive units, located on the base substrate and arranged in an array mode in a first direction and a second direction, wherein the first direction and the second direction are both parallel to the base substrate and intersect, each of the plurality of first drive units comprises at least one first drive portion and a drive connecting portion, each of the at least one first drive portion comprises at least one drive port portion, each of the at least one drive port portion comprises a plurality of drive ports, and the drive connecting portion is configured to be connected with a drive circuit; and
a plurality of first wires, each of the plurality of first wires extending in the second direction, wherein each of the plurality of first wires is connected with the first drive unit, and the plurality of first wires are located in a same conductive pattern layer with the first drive unit;
wherein the light-emitting substrate further comprises a second drive unit which is located on the base substrate, at least a portion of the second drive unit is located between two first drive units which are adjacent in the first direction, and the second drive unit comprises a plurality of connecting ends, and a count of the plurality of connecting ends in the second drive unit is larger than a count of the plurality of drive ports in the drive port portion.

2. The light-emitting substrate according to claim 1, wherein the second drive unit is located in in the same conductive pattern layer.

3. The light-emitting substrate according to claim 1 or 2, further comprising a plurality of second wires each of which extends in the second direction, and each of the plurality of second wires being connected with one of the plurality of connecting ends in the second drive unit, wherein
the plurality of second wires are located in the same conductive pattern layer.

4. The light-emitting substrate according to claim 1 or 2, further comprising:
a light-emitting element, connected with the plurality of drive ports in the drive port portion, wherein the drive circuit transmits a drive signal to the drive port portion in the first drive portion through the drive connecting portion so that the light-emitting element emits light; and
a sensor, which is connected with the plurality of connecting ends in the second drive unit and is configured to monitor a temperature of the light-emitting substrate.

5. The light-emitting substrate according to claim 3, wherein
the plurality of first wires comprise a first scanning line and a second scanning line, the first scanning line and the second scanning line which have the smallest distance in the first direction are located between two adjacent first drive units, the first scanning line is connected with one of the two adjacent first drive units, and the second scanning line is connected with the other one of the two adjacent first drive units; and
at least a portion of the second drive unit is located between the first scanning line and the second scanning line which have the smallest distance in the first direction.

6. The light-emitting substrate according to claim 5, wherein the plurality of connecting ends of the second drive unit comprise a first connecting end, a second connecting end, a third connecting end and a fourth connecting end;
the plurality of second wires comprise a first signal line, a second signal line, a third signal line and a fourth signal line, wherein
the first signal line is connected with the first connecting end and configured to transmit a first common voltage signal, the second signal line is connected with the second connecting end and configured to transmit a first power signal; the third signal line is connected with the third connecting end and configured to transmit a first input signal, and the fourth signal line is connected with the fourth connecting end and configured to transmit a first output signal.

7. The light-emitting substrate according to claim 6, wherein the drive port portion comprise two drive ports.

8. The light-emitting substrate according to claim 6 or 7, wherein the first scanning line and the first signal line are of an integrated structure; and
the first scanning line comprises a main body portion and a protruding portion, the main body portion extends in the second direction, the protruding portion protrudes relative to the main body portion in the first direction, and the protruding portion and the first connecting end of the second drive unit are of an integrated structure.

9. The light-emitting substrate according to claim 8, wherein
the second connecting end, the third connecting end and the fourth connecting end are all located between the first scanning line and the second scanning line which have the smallest distance in the first direction; and
the second signal line, the third signal line and the fourth signal line are all located between the first scanning line and the second scanning line which have the smallest distance.

10. The light-emitting substrate according to claim 8 or 9, wherein
the second signal line is located between the first connecting end and the third connecting end in the first direction, the second connecting ends of the second drive units located in a same column are connected with the same second signal line, and
the fourth connecting end of the second drive unit is connected with the third connecting end of the second drive unit adjacent thereto through the fourth signal line.

11. The light-emitting substrate according to claim 6, wherein
the first connecting end, the second connecting end, the third connecting end and the fourth connecting end are arranged in an array with two rows and two columns in the first direction and the second direction; and the second connecting end and the fourth connecting end are adjacent to each other in the first direction, and the first connecting end and the second connecting end are adjacent to each other in the second direction.

12. The light-emitting substrate according to claim 11, wherein in second drive units located in the same column in the second direction, the third connecting end of the second drive unit located in a N^{th} row is located on a side of the fourth connecting end of the second drive unit, away from the second drive unit located in a (N+1)^{th} row, and N is a positive integer.

13. The light-emitting substrate according to claim 1 or 2, wherein
the drive connecting portion and the second drive unit are arranged at intervals in the first direction and the second direction.

14. The light-emitting substrate according to claim 1 or 2, wherein the first drive unit and the second drive unit are arranged at intervals in the first direction; and/or the first drive unit and the second drive unit are arranged at intervals in the second direction.

15. The light-emitting substrate according to claim 1 or 2, wherein the drive connecting portion in the first drive unit comprises a plurality of drive connecting end; and
the first drive unit comprises one first drive portion which is connected with one of the plurality of drive connecting ends.

16. The light-emitting substrate according to claim 1 or 2, wherein the drive connecting portion in the first drive unit comprises a plurality of drive connecting ends,
the first drive unit comprises four first drive portions, the plurality of drive connecting ends comprise four drive sub-connecting ends, and the four first drive portions are in one-to-one correspondence with the four drive sub-connecting ends.

17. The light-emitting substrate according to claim 5, comprising a display portion, and a bonding region which is located at one side of the display portion in the second direction, wherein the bonding region comprises a plurality of bonding sub-regions; the light-emitting substrate comprises a plurality of drive groups, wherein
each of the plurality of drive groups comprises a plurality of drive unit columns which are sequentially arranged in the first direction, each of the plurality of drive unit columns comprises at least one first drive unit, one of the plurality of first wires connected with the first drive unit in the drive group extends to one of the plurality of bonding sub-regions;
at least one second drive unit is arranged in the drive group, and the second wire connected with the at least one second drive unit extends to the bonding sub-region.

18. The light-emitting substrate according to claim 17, wherein the drive group is provided with a column of second drive units; and in the first direction, counts of the drive unit columns at two sides of the second drive unit in the drive group are equal.

19. The light-emitting substrate according to claim 17 or 18, wherein
the plurality of drive unit columns comprise a first drive unit column, a second drive unit column, and a plurality of third drive unit columns;
the first drive unit column and the second drive unit column are arranged adjacent to each other in the first direction, at least one third drive unit column is located on a side, away from the second drive unit column, of the first drive unit column, and at least one third drive unit column is located on a side, away from the first drive unit column, of the second drive unit column; and
at least a portion of second drive unit is located between the first drive unit column and the second drive unit column, and a count of the plurality of drive unit columns in the drive group is an even number.

20. The light-emitting substrate according to claim 19, wherein the drive group is provided with a column of second drive units; and in the first direction, counts of the third drive unit columns at two sides of the second drive unit in the drive group are equal.

21. The light-emitting substrate according to claim 20, wherein one of the plurality of second wires that is connected with the second drive units in the drive group extends to a middle portion of the bonding sub-region.

22. The light-emitting substrate according to claim 19 or 20, wherein the plurality of first wires further comprise a third scanning line, a fourth scanning line and a fifth scanning line;
in the first direction, the second scanning line, the third scanning line, the fourth scanning line, the fifth scanning line and the first scanning line that are connected with the first drive unit are sequentially arranged, and the first drive unit is located between the third scanning line and the fourth scanning line;
the first scanning line is configured to transmit a second common voltage signal; the second scanning line is configured to transmit a second power signal; the third scanning line is configured to transmit a third power signal; the fourth scanning line is configured to transmit a second output signal; the fifth scanning line is configured to transmit a third output signal; and
in the first direction, a width of the second scanning line, a width of the fourth scanning line and a width of the fifth scanning line are all smaller than a width of the first scanning line and smaller than a width of the third scanning line.

23. The light-emitting substrate according to claim 22, wherein
first scanning lines connected with the first drive units in all of the plurality of third drive unit columns have a same width which is a first width; and
third scanning lines connected with the first drive units in all of the plurality of third drive unit columns have the same width which is a second width, and the first width and the second width are approximately equal.

24. The light-emitting substrate according to claim 23, wherein
a width of the first scanning line connected with first drive units in the first drive unit column is a third width, and the third width is smaller than the first width; and
a width of the third scanning line connected with first drive units in the second drive unit column is a fourth width, and the fourth width is smaller than the second width.

25. The light-emitting substrate according to claim 23 or 24, wherein the third width is 80% to 90% of the first width; and/or the fourth width is 80% to 90% of the second width.

26. The light-emitting substrate according to claim 22, wherein an average length of portions, extending into the bonding sub-region, of the first wires connected with the first drive units in the first drive unit column is a first length; and
an average length of portions, extending into the bonding sub-region, of the second wires connected with the second drive units in the drive group is a second length, and the second length is smaller than the first length.

27. The light-emitting substrate according to claim 1 or 2, wherein the first drive unit comprises a plurality of first leads, at least one second lead and at least one third lead which are located in the conductive pattern layer;
adjacent drive port portions are connected through one of the plurality of first leads; the first drive portion is connected with the drive connecting portion through one of the at least one second lead; and the first drive portion is connected with the third scanning line through one of the at least one third lead.

28. A backlight module, comprising the light-emitting substrate according to any one of claims 1 to 27.

29. A display apparatus, comprising the backlight module according to claim 28.
